# EUROPÄISCHE PATENTSCHRIFT

(11) **EP 4 402 997 B1**
(45) Veröffentlichungstag und Bekanntmachung des Hinweises auf die Patenterteilung: **11.03.2026**
(21) Anmeldenummer: 22773465.4
(22) Anmeldetag: 05.09.2022
(51) Int. Cl.: G01D 11/24, H05K 7/14

(54) **FELDGERÄT**
FIELD DEVICE
APPAREIL DE TERRAIN

(30) Priorität: 14.09.2021 DE 102021123664
(43) Veröffentlichungstag der Anmeldung: 24.07.2024
(73) Patentinhaber: Endress+Hauser SE+Co. KG, 79689 Maulburg (DE)
(72) Erfinder: KOPP, Daniel, 79541 Lörrach (DE); KROPF, Martin, 79585 Steinen (DE); MEINHARDT, Alexander, 79540 Lörrach (DE); RAUCH, Stefan, 79664 Wehr (DE); REICHERT, Philipp, 79585 Steinen-Hägelberg (DE)
(74) Vertreter: Endress + Hauser Group Services (Deutschland) AG+Co. KG
(86) Internationale Anmeldenummer: PCT/EP2022/074581
(87) Internationale Veröffentlichungsnummer: WO 2023/041361

(56) Entgegenhaltungen:
- DE-A1- 102007 037 364

## Beschreibung

Die Erfindung betrifft ein robust ausgeführtes Feldgerät.

In der Prozessautomatisierungstechnik werden vielfach Feldgeräte eingesetzt, die zur Erfassung oder zur Beeinflussung bestimmter Prozessvariablen dienen. Zur Erfassung der jeweiligen Prozessvariable umfasst das Feldgerät je nach Typ spezifische elektronischen Komponenten, um das entsprechende Messprinzip umsetzen. Je nach Auslegung kann der jeweilige Feldgeräte-Typ somit beispielsweise zur Messung eines Füllstandes, eines Durchflusses, eines Druckes, einer Temperatur, eines pH-Wertes und/oder einer Leitfähigkeit zum Einsatz kommen. Verschiedenste solcher Feldgeräte-Typen werden von der Firmengruppe Endress + Hauser hergestellt und vertrieben.

Die elektronischen Module des jeweiligen Feldgeräte-Typs sind oftmals in einem Metall-Gehäuse untergebracht, welches zum Schutz der Komponenten als Faraday'scher Käfig dient und entsprechend geerdet ist. Jedoch gibt es viele Anwendungen, bei denen ein nicht-metallisches Gehäuse vorteilhaft bzw. erforderlich ist. So basieren beispielsweise Feldgeräte, die in korrosiven Umgebungen, wie etwa küstennahen Standorten sowie bei Prozessen mit sauren oder alkalischen Medien eingesetzt werden, vorzugsweise auf einem Kunststoff-basierten Gehäuse. Die elektronischen Module werden in solchen Fällen durch eine zusätzliche, elektrisch leitfähige Einfassung geschützt, welche als Faraday'scher Käfig fungiert und mitsamt den elektronischen Modulen innerhalb des Kunststoff-basierten Gehäuses angeordnet ist. Ein entsprechendes Feldgerät ist beispielsweise in der Veröffentlichungsschrift DE 10 2015 107 306 A1 gezeigt. Ein Flüssigkeits-Sensor, dessen Metall-Gehäuse zur Verbesserung der mechanischen Eigenschaften eine zusätzliche Kunststoff-Beschichtung aufweist, ist in der Veröffentlichungsschrift DE 10 2007 037364 A1 beschrieben.

Unabhängig vom jeweiligen Feldgeräte-Typ ist der Sensor Prinzip-bedingt mit direktem Kontakt zum Inneren des Prozess-Behälters anzubringen. Vor allem zu Explosionsschutz-Zwecken wird jedoch oftmals eine räumliche Trennung zwischen den aktiven, also mit Strom versorgten Modulen und dem überwiegend passiven Sensor gefordert. Hierzu kann das Feldgerät einen Messgeräte-Hals umfassen, über den der Sensor mit dem Gehäuse verbunden ist, in welchem insbesondere temperaturempfindliche elektronische Module des Füllstandmessgerätes, wie Schnittstellen-Module zur Kommunikation nach außen untergebracht sind. Dabei ist in dem Messgeräte-Hals je nach Anforderung eine entsprechende Explosionsschutz-Barriere angeordnet. Zusätzlich oder alternativ zu Explosionsschutzanforderungen muss der Messgeräte-Hals gegebenenfalls weitere Schutzfunktionen erfüllen: Je nach Anwendung herrschen im Inneren des Behälters hohe Temperaturen, hoher Druck oder gefährliche Gase vor. Daher muss der Messgeräte-Hals je nach Anwendung als Druckdichtung, Temperaturbarriere und/oder als Medien-Abdichtung fungieren.

Im Falle eines Kunststoff-basierten Gehäuses ist dessen Montage am Messgeräte-Hals problematisch, da die Stabilität einer etwaigen Gewinde-Befestigung am Gehäuse ggf. nach wenigen Schraub-Zyklen verloren geht, insbesondere, sofern der Messgeräte-Hals aus einem harten Material wie Stahl gefertigt ist. Der Erfindung liegt daher die Aufgabe zugrunde, ein insgesamt robustes Feldgerät bereitzustellen.

Gelöst wird diese Aufgabe durch ein Feldgerät, das folgende Komponenten umfasst:
- Ein elektrisch isolierendes Gehäuse, mit
   ∘ einem Innenraum, und
   ∘ einer Durchführung, die sich entlang einer Geräte-Achse an den Innenraum anschließt,
- eine im Innenraum befestigbare Einfassung aus einem elektrisch leitfähigen Material, welche ausgebildet ist, ein erstes elektronisches Modul in Bezug zu der Geräte-Achse zumindest radial zu umschließen,
- einen Messgeräte-Hals, der derart an der Einfassung befestigt ist, so dass der Messgeräte-Hals in Richtung der Geräte-Achse ausgerichtet ist und in der Durchführung des Gehäuses mündet, und
- einen Sensor zur Bestimmung der Prozessgröße, welcher an einem dem Gehäuse abgewandten Endbereich des Messgeräte-Halses angeordnet ist.

Vorteilhaft an der erfindungsgemäßen Lösung ist, dass das Gehäuse lediglich indirekt, nämlich über die Einfassung am Messgeräte-Hals befestigt ist. Hierdurch kann auf ein verschleißanfälliges Kunststoff-Gewinde am Gehäuse verzichtet werden. Dennoch ist es auf Basis dieser Auslegung möglich, den Innenraum bspw. zu Explosionsschutz-Zwecken hermetisch dicht, also luftdicht, zu kapseln, wenn das Gehäuse entsprechend ausgelegt ist, bzw. wenn die Durchführung gen Messgeräte-Hals entsprechend abgedichtet ist.

Erfindungsgemäß ist der Messgeräte-Hals mittels einer Gewindeverbindung, welche entlang der Geräte-Achse ausgerichtet ist, an der Einfassung befestigt. Dabei erlaubt es die Erfindung, dass eine solche Gewindeverbindung als stabiles M60-Gewinde oder kleiner ausgelegt ist, da das Kunststoff-Gehäuse hiervon nicht betroffen ist.

Erfindungsgemäß ist es nicht fest vorgeschrieben, wie das Gehäuse mechanisch an der Einfassung befestigt ist. Beispielsweise können in die Einfassung und in das Gehäuse korrespondierende, erste Schraublöcher eingelassen sein, um die Einfassung mittels einer ersten Schraubverbindung im Innenraum zu befestigen. Dabei ist es durch die erfindungsgemäße Auslegung des Feldgerätes nicht kritisch, wie stabil die Befestigung des Gehäuses an der Einfassung konzipiert ist. Daher kann die mechanische Belastbarkeit der ersten Schraubverbindung deutlich niedriger als die Befestigung des Messgeräte-Halses an der Einfassung ausgelegt werden.

Unter EMV-Aspekten ist es ggf. erforderlich, dass das Elektronik-Modul in Bezug zur Geräte-Achse von der Einfassung nicht nur radial, sondern auch axial umschlossen wird. In einer Weiterbildung der Einfassung kann diese hierzu in Bezug zur Geräte-Achse dennoch einen dem Messgeräte-Hals abgewandten, offenen Endbereich umfassen, welcher allerdings durch eine Leiterplatte mit etwaigen weiteren Elektronik-Modulen gedeckelt wird. Hierdurch können auch unter platzsparender Nutzung des Gehäuse-Innenraums etwaige EMV-Vorgaben erfüllt werden.

Durch den erfindungsgemäßen Aufbau verhält sich das Kunststoff-Gehäuse bezüglich der Befestigung zum Messgeräte-Hals wie ein Metall-Gehäuse, so dass das Feldgerät mittels folgender Verfahrensschritte gefertigt werden kann:
- Anordnen des ersten Elektronik-Moduls innerhalb der Einfassung,
- Anschließendes oder vorheriges Befestigen der Einfassung im Innenraum, und
- Befestigen der Einfassung am Messgeräte-Hals, so dass der Messgeräte-Hals in der Durchführung des Gehäuses angeordnet ist.

Anhand der nachfolgenden Figuren wird die Erfindung näher erläutert. Gezeigt wird:
Fig. 1: Ein Feldgerät zur Bestimmung einer Prozessgröße in einem Behälter,
Fig. 2: eine Querschnittsansicht des erfindungsgemäßen Feldgerätes im Bereich der Einfassung, und
Fig. 3: eine Detailansicht der Einfassung.

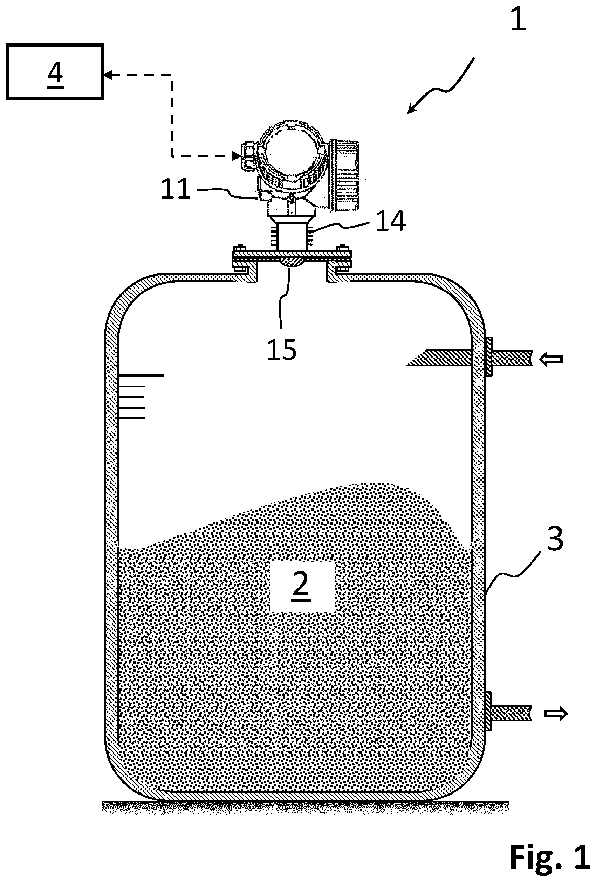

Zum prinzipiellen Verständnis der Erfindung ist in Fig. 1 ein Prozess-Behälter 3 einer Prozessanlage gezeigt, welcher beispielsweise zum Ablauf chemischer bzw. biologischer Reaktionen, oder zur Speicherung von Edukten 2 dient. Dabei kann der Behälter 3 je nach Art des Füllgutes 2 und je nach Einsatzgebiet bis zu mehr als 100 m hoch sein. In Abhängigkeit des Prozesses ist als Prozessgröße innerhalb des Behälters 3 beispielsweise ein Füllstand, ein Grenzstand, eine Temperatur, ein pH-Wert oder eine Leitfähigkeit zu bestimmen. Von der Art des Füllgutes 2 und dem Einsatzgebiet hängen auch die Bedingungen im Behälter 3 ab. So kann es im Falle von exothermen Reaktionen beispielsweise zu hoher Temperatur- und Druckbelastung kommen. Bei staubhaltigen oder entzündlichen Stoffen sind im Behälter-Inneren entsprechende Explosionsschutzbedingungen einzuhalten.

Um die spezifische Prozessgröße bestimmen zu können, ist ein Feldgerät 1 mit einem entsprechenden Sensor 15 in einer bekannten Einbauposition am Behälter 3 angebracht. Dabei ist das Feldgerät 1 derart an einer Öffnung des Behälters 3 befestigt bzw. ausgerichtet, dass lediglich der Sensor 15 über eine Behälter-Öffnung Zugang zum Behälter 3 hat. Die weiteren Module 13, 19 des Feldgerätes 1 sind außerhalb des Behälters 3 in einem Kunststoff-basierten Gehäuse 12 des Feldgerätes 1 entsprechend korrosions- und witterungsbeständig untergebracht.

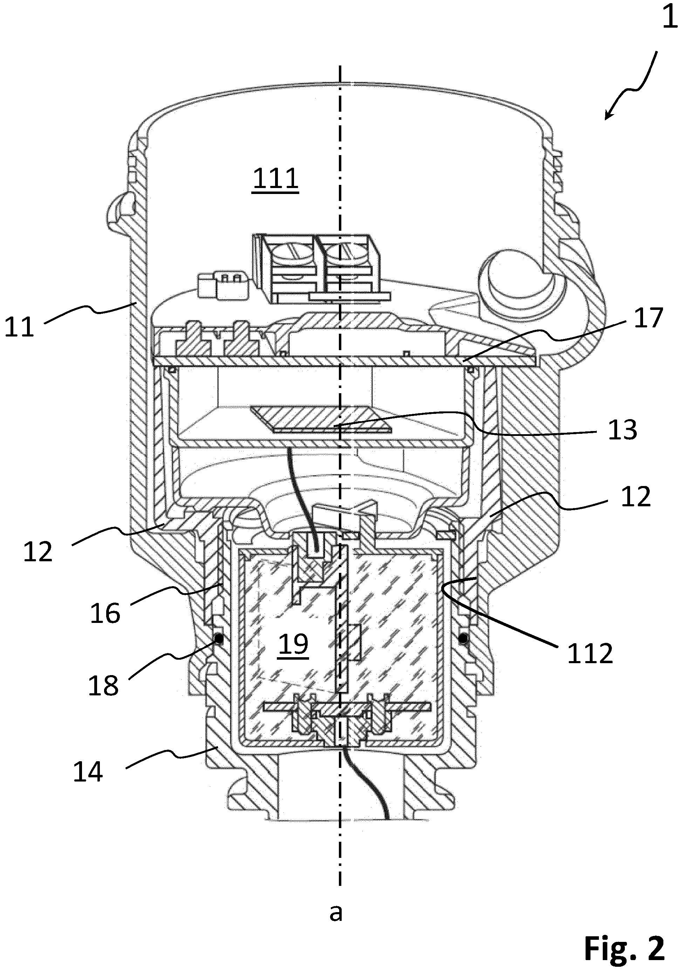

Wie in Fig. 1 und Fig. 2 gezeigt ist, kann im Gehäuse 12 des Feldgerätes 1 als elektronisches Modul 13 bspw. eine Schnittstelle angeordnet sein, welche das Feldgerät 1 über ein entsprechendes Protokoll wie etwa "4-20 mA", "PROFIBUS", "HART", "WLAN" oder "Ethernet" mit einer übergeordneten Einheit 4, wie z. B. einem lokalen Prozessleitsystem oder einem dezentralen Server-System verbindet. Hierüber kann die gemessene Prozessgröße übermittelt werden, beispielsweise um gegebenenfalls Zu- oder Abflüsse des Behälters 3 zu steuern. Es können aber auch anderweitige Informationen über den allgemeinen Betriebszustand des Feldgerätes 1 kommuniziert werden. Die separate Konzipierung der Schnittstellen als eigenständiges Modul 13 weist den Vorteil auf, dass dieses Modul 13 nicht lediglich in einem speziellen Feldgeräte-Typ einsetzbar ist. Alternativ zu einer Schnittstelle kann das in Fig. 2 gezeigten Modul 13 jedoch auch jegliche andere Funktion aufweisen.

Bei der in Fig. 2 gezeigten Ausführungsvariante weist das Gehäuse 11 des Feldgerätes 1 in Bezug zu einer definierten Geräte-Achse a einen zylinderförmigen Innenraum 111 auf. Damit die im Innenraum 111 angeordneten Module 13 unter EMV-technischen Gesichtspunkten (*"ElektroMagnetische Verträglichkeit*") geschützt sind, ist dort zusätzlich eine Einfassung 12 angeordnet, welche das oder die elektronischen Module 13 in Bezug zu der Geräte-Achse a radial umschließt. Dadurch, dass die Einfassung 12 aus einem elektrisch leitfähigen Material gefertigt ist, wirkt die Einfassung 12 somit als Faraday'scher Käfig. Axial ist die Einfassung 12 gen Sensor-abgewandtem Endbereich nicht geschlossen, sondern weist einen kreisrunden, offenen Endbereich auf. Dieser Endbereich wird in der gezeigten Ausführungsvariante von einer orthogonal zur Geräte-Achse a angeordneten Leiterplatte 17 abgeschlossen. Hierdurch wird das Modul 13 auch gen Sensor-abgewandtem Endbereich der Einfassung 12 EMV-technisch geschützt. Dabei können auf der Leiterplatte 17 beispielsweise Anschlüsse zur externen Kontaktierung des Feldgerätes 1 nach außen angebracht sein. Vorteilhaft hieran ist, dass die Integrationsdichte der Komponenten 12, 13, 17 innerhalb des Gehäuses 11 erhöht wird, so dass der Innenraum 111 insgesamt kompakter ausgelegt werden kann. Alternativ zu der gezeigten Ausführungsform ist es auch denkbar, dass die Einfassung 12 anstelle der Leiterplatte 17 durch einen ggf. integrierten, ebenfalls leitfähigen Deckel abgeschlossen ist.

Dadurch, dass das Feldgerät 1 mit Ausnahme des Sensors 15 außerhalb des Behälters 3 angeordnet ist, wird einerseits der Explosions-Schutz innerhalb des Behälters 3 erhöht. Andererseits werden hierdurch Temperatur- und Druck-empfindliche Bauteile 13, 17 im Innenraum 111 des Feldgeräte-Gehäuses 11 vor Temperatur- und Druck-Belastung aus dem Behälter-Inneren geschützt. Hierzu ist das Gehäuse 12, wie insbesondere in Fig. 2 dargestellt ist, außerdem durch einen separaten Gehäuseteil in Form eines Messgeräte-Halses 14 vom Sensor 15 bzw. von der Behälter-Öffnung beabstandet. Dabei ist auch der Messgeräte-Hals 14 entlang der Geräte-Achse a ausgerichtet, so dass der Sensor-seitige Endbereich des Messgeräte-Halses 14 im befestigten Zustand des Feldgerätes 1 in das Innere des Behälters 3 gerichtet ist. Der Sensor-abgewandte Endbereich des Messgeräte-Halses 14 mündet entsprechend in einer Durchführung 112 im Gehäuseboden des Gehäuses 12, so dass der Sensor 15 über den Messgeräte-Hals 14 und die Durchführung 112 elektrisch mit dem elektronischen Modul 13 im Innenraum 111 des Gehäuses 12 kontaktiert werden kann.

Wie in Fig. 2 gezeigt ist, kann bei Bedarf ein etwaiges zweites elektronisches Modul 19 auch direkt im Messgeräte-Hals 14 angeordnet werden, sofern beispielsweise kurze Hochfrequenz-Signalwege bzw. eine Sensor-nahe Signal-Auswertung erforderlich ist und das zweite Modul 19 entsprechend stabil gekapselt ist. Durch diese Auslagerung des zweiten Moduls 19 kann außerdem der Platzverbrauch im Gehläuse-Innenraum 111 weiter minimiert werden. Dabei kann der Messgeräte-Hals 14 zur thermischen Entkopplung im Falle einer metallischen Auslegung zudem entsprechende Kühlrippen aufweisen, wie in Fig. 1 und Fig. 2 angedeutet ist.

Da das Feldgerät 1 entsprechend der Darstellung in Fig. 1 über den Messgeräte-Hals 14 am Behälter 3 befestigt wird, muss das Gehäuse 11 mitsamt den im Innenraum 111 befindlichen Komponenten 12, 13, 17, bspw. mittels einer M60-Gewindeverbindung 16, möglichst stabil am Messgeräte-Hals 14 befestigt sein. Gemäß Fig 2 weist der Messgeräte-Hals 14 hierzu am Sensor-abgewandten Endbereich auf Höhe der Durchführung 112 ein entsprechendes Außengewinde auf, wobei die Gewindeverbindung 16 wiederum entlang der Geräte-Achse a ausgerichtet ist.

Erfindungsgemäß ist das korrespondierende Innengewinde der Gewindeverbindung 16 nicht in den Kunststoff der Durchführung 112 eingelassen. Vielmehr umfasst die metallische Einfassung 12 im Bereich der Durchführung 112 ein entsprechendes Außengewinde für das Innengewinde des Messgeräte-Halses 14. Da die Einfassung 12 wiederum im Innenraum 111 des Gehäuse 11 befestigt ist, wird dieser mitsamt dem geschirmten elektronischen Modul 13 somit indirekt über die Einfassung 12 mechanisch mit dem Messgeräte-Hals 14 verbunden. Hierdurch wird die maximal mögliche Anzahl an Verschraubzyklen der Gewindeverbindung 16 nicht durch den Kunststoff des Gehäuses 11 limitiert. Bemerkbar macht sich dies insbesondere dann, wenn das Gehäuse 11 beispielsweise zu Service- und Wartungsarbeiten periodisch wiederkehrend abgeschraubt werden muss.

Bei der in Fig. 2 gezeigten Ausführungsvariante des erfindungsgemäßen Feldgerätes 1 wird das Gehäuse 11 auf Höhe der Durchführung 112 zum Messgeräte-Hals 14 hin durch einen Dichtring 18 abgedichtet. Hierdurch wird der Innenraum 111 des Gehäuses 11 nach außen hermetisch abgedichtet, sofern auch das Gehäuse 11 als solches hermetisch dichtend ausgelegt ist. Dies begünstigt wiederum die explosionssichere Auslegung des Feldgerätes 1.

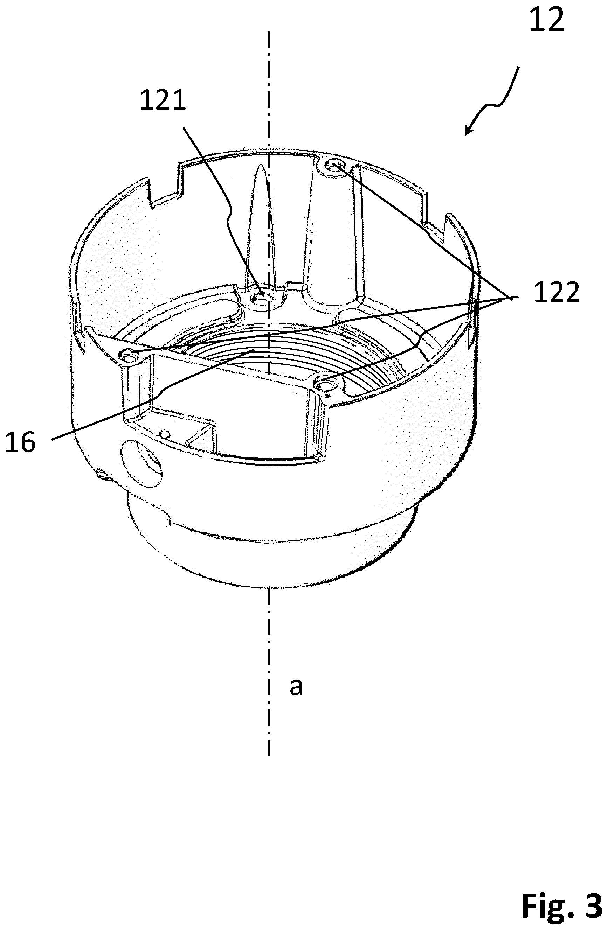

Das Innengewinde der Gewindeverbindung 16 auf Seiten der Einfassung 12 ist detailliert in Fig. 3 gezeigt. Aus dieser Detailansicht wird außerdem ersichtlich, wie die Einfassung 12 im Innenraum 111 des Gehäuses 11 befestigt werden kann: Hierzu sind in einer Stufe der Einfassung 12, in welcher sich die Einfassung 12 entlang der Geräte-Achse a gen Messgerät-Hals 14 entsprechend verengt, erste Schraublöcher 121 eingelassen. Mittels der resultierenden ersten Schraubverbindungen neben der Durchführung 112 kann die Einfassung 12 im Gehäuse 11 befestigt werden. Auch die Leiterplatte 17 kann mittels zumindest einer zweiten Schraubverbindung an der Einfassung 12 befestigt werden. Wie in Fig. 3 zu erkennen ist, umfasst die Einfassung 12 hierzu an der axial Sensor-abgewandten Öffnung drei Schraublöcher 122, die parallel zur Geräte-Achse a ausgerichtet sind.

### Bezugszeichenliste

- 1: Feldgerät
- 2: Füllgut
- 3: Behälter
- 4: Übergeordnete Einheit
- 11: Gehäuse
- 12: Einfassung
- 13: Elektronik-Modul
- 14: Messgeräte-Hals
- 15: Sensor
- 16: Gewindeverbindung
- 17: Leiterplatte
- 18: Dichtring
- 19: Zweites Elektronik-Modul
- 111: Innenraum des Gehäuses
- 112: Durchführung
- 121: Erste Schraublöcher
- 122: Zweite Schraublöcher
- a: Geräte-Achse

## Patentansprüche

1. Feldgerät zur Bestimmung einer Prozessgröße, umfassend:
- ein elektrisch isolierendes Gehäuse (11), mit
∘ einem Innenraum (111), und
∘ einer Durchführung (112), die sich entlang einer Geräte-Achse (a) an den Innenraum (111) anschließt,
- eine im Innenraum (111) befestigte Einfassung (12) aus einem elektrisch leitfähigen Material, welche ausgebildet ist, ein erstes elektronisches Modul (13) in Bezug zu der Geräte-Achse (a) zumindest radial zu umschließen,
- einen Messgeräte-Hals (14), der derart an der Einfassung (12) befestigt ist, so dass der Messgeräte-Hals (14) in Richtung der Geräte-Achse (a) ausgerichtet ist und in der Durchführung (112) des Gehäuses (11) mündet, und
- einen Sensor (15) zur Bestimmung der Prozessgröße, welcher an einem dem Gehäuse (11) abgewandten Endbereich des Messgeräte-Halses (14) angeordnet ist,
**dadurch gekennzeichnet, dass**
der Messgeräte-Hals (14) mittels einer Gewindeverbindung (16), welche entlang der Geräte-Achse (a) ausgerichtet ist, an der Einfassung (12) befestigt ist.

2. Feldgerät nach Anspruch 1, wobei die Gewindeverbindung (16) maximal als M60-Gewinde ausgelegt ist.

3. Feldgerät nach einem der vorhergehenden Ansprüche, wobei in die Einfassung (12) und in das Gehäuse (11) korrespondierende, erste Schraublöcher (121) eingelassen sind, um die Einfassung (12) mittels einer ersten Schraubverbindung im Innenraum (111) zu befestigen.

4. Feldgerät nach einem der vorhergehenden Ansprüche, wobei die Einfassung (12) in Bezug zur Geräte-Achse (a) einen dem Messgeräte-Hals (14) abgewandten, offenen Endbereich umfasst, und wobei der offene Endbereich der Einfassung (12) durch eine Leiterplatte (17) gedeckelt ist.

5. Feldgerät nach einem der vorhergehenden Ansprüche, wobei das Gehäuse (11) derart ausgelegt ist und die Durchführung (112) derart abgedichtet ist, so dass der Innenraum (111) hermetisch dicht gekapselt ist.

6. Verfahren zur Fertigung des Feldgerätes (1) nach einem der vorhergehenden Ansprüche, folgende Verfahrensschritte umfassend:
- Anordnen des ersten Elektronik-Moduls (13) innerhalb der Einfassung (12),
- Befestigen der Einfassung (12) im Innenraum (111), und
- derartiges Befestigen des Messgeräte-Halses (14) an der Einfassung (12), so dass der Messgeräte-Hals (14) in der Durchführung (112) des Gehäuses (11) angeordnet ist.

## Claims

1. Field device for determining a process variable, comprising:
- an electrically insulating housing (11), with
∘ an interior space (111), and
∘ a feedthrough (112) extending along a device axis (a) to the interior space (111),
- a surround (12) made of an electrically conductive material, which is fixed in the interior space (111) and is designed to form a first electronic module (13) at least radially in relation to the device axis (a),
- a measuring device neck (14) which is fastened to the surround (12) in such a way that the measuring device neck (14) is aligned in the direction of the device axis (a) and is arranged in the passage (112) of the housing (11) , and
- a sensor (15) for determining the process variable, which is arranged at an end region of the measuring device neck (14) facing away from the housing (11),
**characterized in that**
the measuring device neck (14) is attached to the surround (12) by means of a threaded connection (16) which is aligned along the device axis (a).

2. Field device according to claim 1, wherein the threaded connection (16) is designed as a maximum M60 thread.

3. Field device according to one of the preceding claims, wherein corresponding first screw holes (121) are embedded in the surround (12) and in the housing (11) in order to fasten the surround (12) to the housing (11) by means of a
first screw connection in the interior (111).

4. Field device according to one of the preceding claims, wherein the surround (12) comprises an open end region facing away from the measuring device neck
(14), and wherein the open
The end area of the surround (12) is covered by a printed circuit board (17).

5. Field device according to one of the preceding claims, wherein the housing (11) is designed and the feedthrough (112) is sealed in such a way that the interior (111) is hermetically sealed.

6. Method for manufacturing the field device (1) according to one of the preceding claims, comprising the following method steps:
- arranging the first electronic module (13) within the enclosure (12),
- fastening the enclosure (12) in the interior (111), and
- securing the measuring device neck (14) to the enclosure (12) in such a way that the measuring device neck (14) is arranged in the feedthrough (112) of the housing (11).

## Revendications

1. Appareil de terrain pour déterminer une grandeur de processus, comprenant :
- un boîtier électriquement isolant (11), avec
∘ un espace intérieur (111), et
∘ un passage (112) qui s'étend le long d'un axe (11) de l'appareil (a) est raccordé à l'espace intérieur (111),
- une bordure (12) en matériau électriquement conducteur, fixée dans l'espace intérieur (111) et conçue pour former un premier module électronique (13) au moins radialement par rapport à l'axe (a) de l'appareil,
- un col de mesure (14) qui est fixé à l'enceinte (12) de telle sorte que le col de mesure (14) soit orienté dans la direction de l'axe (a) de l'appareil et , et
- un capteur (15) pour déterminer la grandeur de processus, qui est disposé sur une zone d'extrémité du col (14) de l'appareil de mesure opposée au boîtier (11),
**caractérisé en ce que**
le col (14) de l'appareil de mesure est fixé à l'enceinte (12) au moyen d'un raccord fileté (16) qui est aligné le long de l'axe (a) de l'appareil.

2. Appareil de terrain selon la revendication 1, dans lequel le raccord fileté (16) est conçu au maximum comme
filetage M60 à.

3. Appareil de terrain selon l'une des revendications précédentes, dans lequel des premiers trous de vis (121) correspondants sont pratiqués dans la monture (12) et dans le boîtier (11) afin de fixer la monture (12) au moyen d'une premier raccord à vis dans l'espace intérieur (111).

4. Appareil de terrain selon l'une des revendications précédentes, dans lequel le cadre (12) comprend, par rapport à l'axe (a) de l'appareil, une zone d'extrémité ouverte opposée au col (14) de l'appareil de mesure
(14) de l'appareil de mesure, et dans lequel le bord ouvert l'extrémité de l'encadrement (12) est recouverte par une carte de circuit imprimé (17).

5. Appareil de terrain selon l'une des revendications précédentes, le boîtier (11) étant conçu et le passage (112) étant étanchéifié de telle sorte que l'espace intérieur (111) est encapsulé de manière hermétique.

6. Procédé de fabrication de l'appareil de terrain (1) selon l'une des revendications précédentes, comprenant les étapes suivantes :
- disposition du premier module électronique (13) à l'intérieur de l'encadrement (12),
- la fixation de l'enceinte (12) dans l'espace intérieur (111), et
- fixation du col de l'appareil de mesure (14) sur le boîtier (12) de telle sorte que le col de l'appareil de mesure (14) soit disposé dans le passage (112) du boîtier (11).
